# EUROPÄISCHE PATENTSCHRIFT

(11) **EP 0 941 580 B1**
(45) Veröffentlichungstag und Bekanntmachung des Hinweises auf die Patenterteilung: **30.01.2002**
(21) Anmeldenummer: 97950088.1
(22) Anmeldetag: 04.11.1997
(51) Int. Cl.: H03L 7/087

(54) **SYNCHRONISATIONSEINRICHTUNG EINER BAUGRUPPE**
SYNCHRONISATION UNIT FOR A COMPONENT GROUP
DISPOSITIF DE SYNCHRONISATION D'UN BLOC DE COMPOSANTS

(30) Priorität: 26.11.1996 EP 96118915
(43) Veröffentlichungstag der Anmeldung: 15.09.1999
(73) Patentinhaber: SIEMENS AKTIENGESELLSCHAFT, 80333 München (DE)
(72) Erfinder: QUIRMBACH, Gerhard, D-80689 München (DE)
(86) Internationale Anmeldenummer: EP9706080
(87) Internationale Veröffentlichungsnummer: WO9824185

(56) Entgegenhaltungen:
- EP-A- 0 139 126
- EP-A- 0 175 888
- EP-A- 0 262 481
- US-A- 4 511 859

## Beschreibung

In der Vermittlungstechnik wird zum Erfüllen erhöhter Betriebssicherheit gefordert, daß zwei Prozessorbaugruppen (eine von beiden ist Master und die andere Slave) redundant arbeiten. Man kann dies durch microsynchronen Betrieb erreichen, wobei der Slave sich auf den Master synchronisiert. Der Master seinerseits synchronisiert sich auf einen externen Referenztakt. Bei Ausfall des externen Referenztaktes muß der (Takt-)Master weiterarbeiten (Holdover-Mode) und der Slave sich weiterhin synchronisieren.

Die wesentliche Anforderung für microsynchronen Betrieb ist, daß der Phasenunterschied zwischen beiden Prozessorbaugruppen nur innerhalb einer sehr geringen Zeitdifferenz (z.B. 5ns) liegen darf.

Zum Erfüllen der Anforderung sind Synchronisationsverfahren vorstellbar, bei denen Phaseninformation zwischen beiden Prozessorbaugruppen ausgetauscht wird. Bei diesen Verfahren können jedoch durch unterschiedliche Gatterlaufzeiten und Reflexionen auf der Verbindungsleitungen zwischen den beiden Baugruppen Verfälschungen dieser Phaseninformation auftreten. Dies führt zu Betriebsinstabilitäten.

Aus Dokument EP 0 175 888 A ist eine Synchronisationseinrichtung gemäß dem Oberbegriff des Anspruchs 1 bekannt.

Der Erfindung liegt die Aufgabe zugrunde, eine Synchronisationseinrichtung einer Baugruppe anzugeben, die die genannte Anforderung in Zusammenarbeit mit der Synchronisationseinrichtung der Partner-Baugruppe erfüllt.

Diese Aufgabe wird durch eine Synchronisationseinrichtung gemäß Anspruch 1 gelöst

Eine Ausführungsform der Erfindung gemäß Anspruch 2 ermöglicht es, die Betriebsweise (Mode) einer Prozessorbaugruppe umzuschalten (z.B. von Takt-Master zu Takt-Slave oder umgekehrt), ohne aus dem microsynchronen Bezeichnung der Erfindung Betrieb zu fallen (Slave/Slave ist nicht möglich). Das Umschalten ist somit also während des microsynchronen Betriebes möglich.

Im folgenden wird ein Ausführungsbeispiel der Erfindung anhand der Zeichnung näher erläutert.

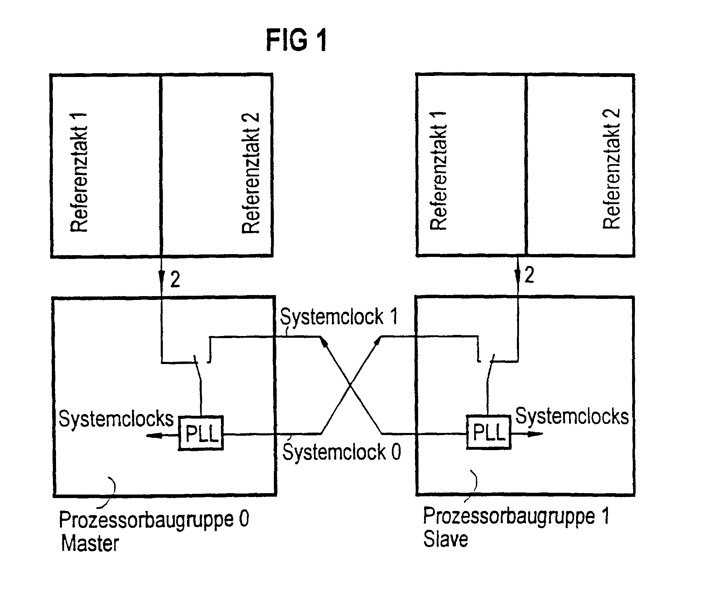

FIG 1 zeigt die Basis-Struktur der gegenseitigen TaktSynchronisation. Nach der dargestellten Struktur ist in einer Baugruppe jeweils ein PLL enthalten, an dessen Eingang ein Schalter vorhanden ist, der zum Umschalten zwischen den Betriebsweisen "Master" und "Slave" einer Baugruppe dient.

Nur eine Prozessorbaugruppe, nämlich die Master-Baugruppe ist synchronisiert auf den externen Referenz-Takt. Die andere Prozessorbaugruppe(Slave-Baugruppe) synchronisiert sich mit einer PLL(Phase Lock Loop) auf die Master-Prozessorbaugruppe. Die Slave-Prozessorbaugruppe läuft mit exakt der gleichen Frequenz und Phase wie die Master Prozessorbaugruppe.

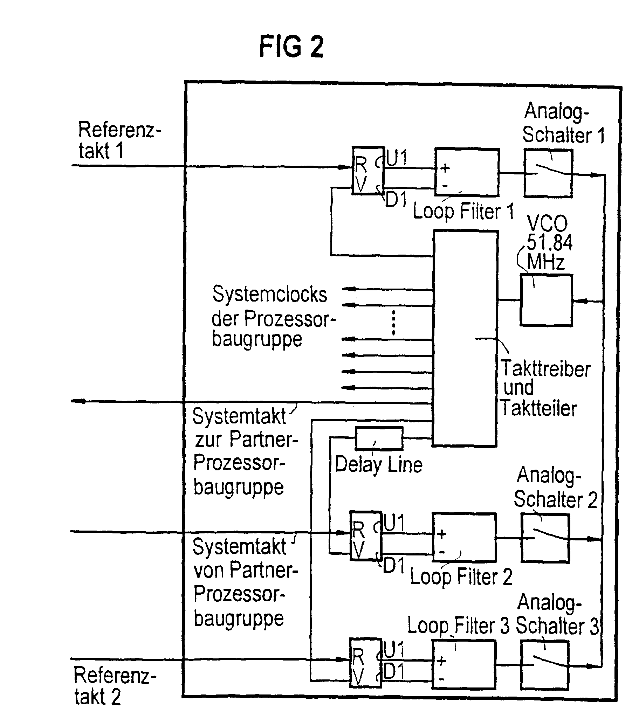

FIG 2 zeigt die Basis-Struktur einer erfindungsgemäßen Synchronisationseinrichtung.

Die Synchronisationseinrichtung umfaßt
- einen VCO, der den Systemtakt der Baugruppe in Abhängigkeit eines an seinem Steuereingang (Ziehspannungseingang) anliegenden Signals erzeugt,
- eine Anordnung, die einen Phasendetektor mit nachgeschaltetem Filter umfaßt und pro Referenztakt jeweils ein Mal vorhanden ist, wobei an dem einen Eingang eines Phasendetektors jeweils ein Referenztakt und an dem anderen Eingang jeweils der Systemtakt anliegt,
- eine in nicht dargestellte Betriebssteuerung (kann bspw. durch den Prozessor der Baugruppe und/oder eine entsprechende Logik reaisiert sein), die den Filtern nachgeschaltete Schalter derart steuert, daß jeweils eines der Ausgangssignale der Filter zum Steuereingang des VCO durchschaltet ist,
- eine Verzögerungseinrichtung, die den Systemtakt vor dem Eingang zum Phasendetektor um die Laufzeitdifferenz zwischen Referenztakt und Systemtakt verzögert.

Die Auswahl der Referenztakte durch (Analog-)Schalter am Ziehspannugseingang des VCO's (siehe FIG 2) hat folgenden Grund. Vor dem Eingang des Phasenvergleichers der 'Partner-Prozessorbaugruppe' ist wegen der Anforderung von maximal 5ns Phasendifferenz zwischen Master und Slave außer der Leitungslaufzeit keine weitere Laufzeit von irgendwelchen Schaltern zur Auswahl eines externen Referenztaktes erlaubt (die Zeitdifferenz zwischen minimaler und maximaler Laufzeit eines solchen Schalters verschlechtert nämlich die Worst Case Phasendifferenz zwischen Master-Baugruppe und Slave-Baugruppe). Deshalb ist erfindungsgemäß für jeden Referenztakt ein eigener Phasenvergleicher vorhanden.

Der Vorteil der in FIG 2 dargestellten Struktur gegenüber der in FIG 1 dargestellten Anordnung, bei der die Schalter am Eingang der PLLs angeordnet sind, besteht also darin, daß keine weitere Laufzeit von irgendwelchen Schaltern zur Auswahl eines externen Referenztaktes zur Phasendifferenz hinzukommt.

Die Leitungslaufzeit kann, falls sie bezüglich der Phasenzeitdifferenz-Anforderung unannehmbar ins Gewicht fällt, mit einem Vorlauf der PLL kompensiert werden. Dazu wird eine Verzögerungseinrichtung (Delay-Line) vor den Vergleichseingang V des Phasendetectors der Partner-Prozessorbaugruppe geschaltet, die den Systemtakt vor dem Eingang zum Phasendetektor um die Laufzeitdifferenz zwischen Referenztakt auf Master-Baugruppe und Systemtakt Slave-Baugruppe verzögert. Bei Verwendung einer solchen Verzögerungseinrichtung wird somit erreicht, daß Referenztakt und Systemtakt (bei Wahl eines die Phasendifferenz am Phasendetektor-Eingang zu Null regelnden PLLs) unabhängig von der Laufzeitdifferenz praktisch phasengleich sind.

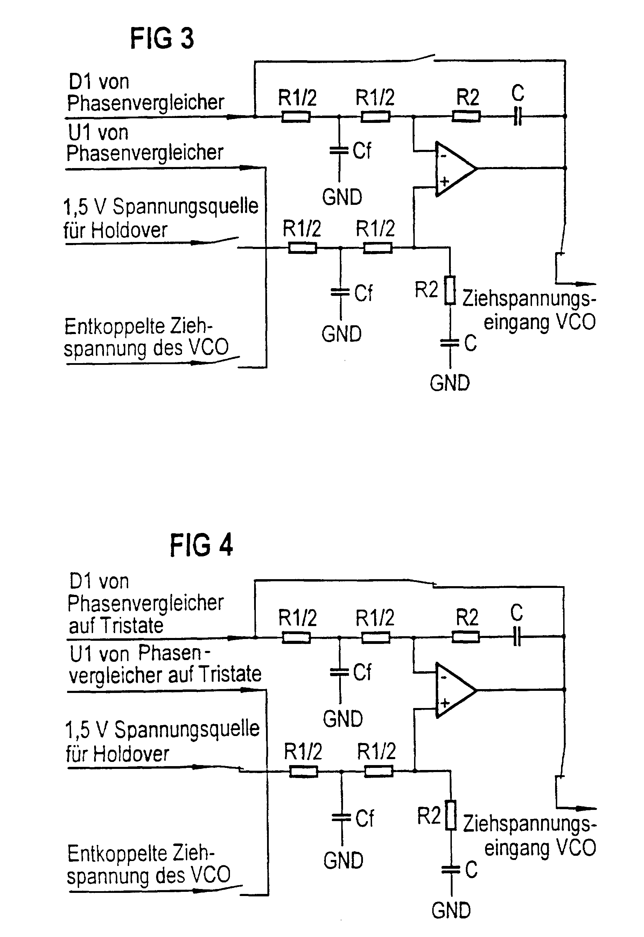

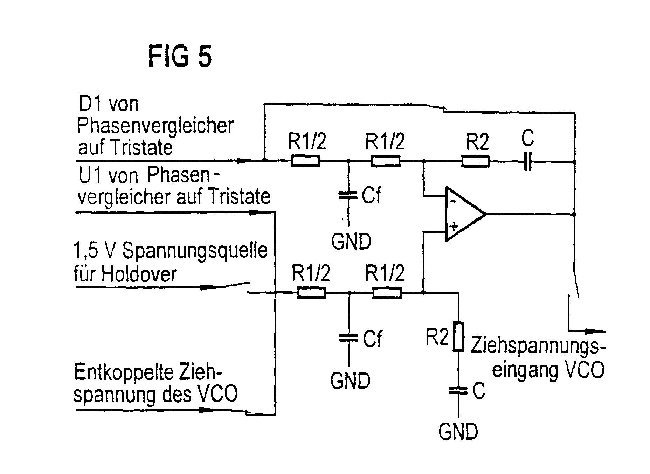

Die genannte Betriebssteuerung steuert außer den in FIG 2 dargestellten Schaltern weitere (in den FIG 3-5 dargestellte) Schalter derart, daß bei einem Filter, dessen Ausgangssignal nicht zum Eingang des VCO durchgeschaltet ist, das Ausgangssignal zu dem einen Filter-Eingang zurückgekoppelt ist und an den anderen Filtereingang das entkoppelte Signal des Steuereingangs des VCO angelegt ist. Dadurch wird das Ausgangssignal eines passiv mitlaufenden Schleifenfilters ständig auf denselben Pegel wie das der aktiven Anordnung geregelt. Dadurch ergibt sich nach dem Umschalten auf einen anderen Referenztakt (externer Referenztakt oder Systemtakt der Partner-Baugruppe) ein optimaler Einschwingvorgang der PLL Phasensprung! Eine Mode-Umschaltung und/oder ein Wechsel der externen Taktquelle ist dadurch ohne Beeinträchtigung des microsynchronen Betriebes möglich.

Die erfindungsgemäße Taktsynchronisation arbeitet ohne Austausch der Phaseninformation. Dies wird dadurch erreicht, daß die Leitungslaufzeit zwischen beiden Prozessorbaugruppen mit einem Vorlauf der PLL kompensiert werden.

Die selektierte PLL hat Null Phasenunterschied am Eingang eines Phasen Detektor's (PD) zwischen dem lokalen Takt und dem externen Referenztakt.

Als Phasendetektor kann bspw. der Phasen Detektor PD-Typ4 aus dem Buch 'Roland Best, Theorie und Anwendung des Phase-locked Loops, ISBN 3-85502-132-5' übernommen und leicht modifiziert werden, so daß er auf die positive Flanke synchronisiert und die zwei Ausgänge auf Tristate geschalted werden können. Der Vorteil dieses Typ's ist :
- Reglung auf Null Phasendifferenz
- Phase und Frequenz sensitives Verhalten.
- Unabhängigkeit von Versorgungsspannung und Temperatur
- Leichte Realisierbarkeit der drei Phasenvergleicher in einem PLD (Programmable Logic Device)
- Großer Bereich von theoretisch ±2π. Dieser ist notwendig, da beim Schalten auf einen anderen Referenztakt die Phase nicht verloren geht, d.h. beim Zurückschalten wird auf die ursprüngliche Flanke synchronisiert. Dies ist notwendig um bei der synchronen TSI-Schnittstelle Datenverlust vorzubeugen.

### Schleifenfilter (Loop Filter):

Es sind drei Schleifenfilter mit folgenden Eigenschaften realisiert :
- Beim Umschalten auf eine externe Referenz ist ein langsamer Einschwingvorgang gefordert. Die Aussteuerung des Ziehspannungseinganges des VCO's muß deshalb beim Eingangsphasensprung klein sein (kleine Verstärkung).
- Beim Umschalten auf die Partner-Prozessorbaugruppe ist ein schneller Einschwingvorgang gefordert. Die Aussteuerung des Ziehspannungseinganges des VCO's muß deshalb beim Eingangsphasensprung groß sein (große Verstärkung).
- Unterschiedliche Frequenzen am Eingang der drei Phasenvergleicher erfordern schließlich ebenfalls entsprechend unterschiedliche Dimensionierungen der Schleifenfilter.

Um zu verhindern, daß der Schleifenfilterausgang den Arbeitsspannungsbereich verlassen kann und in die Sättigung geht (Anschlag der Ausgangsspannung wirkt sich negativ bei dem Einschwingvorgang der PLL aus) gibt es für jedes Schleifenfilter drei Betriebsweisen, die in den FIG 3-5 dargestellt sind und von der genannten Betriebssteuerung mithilfe der dargestellten Schalter gesteuert werden.

### FIG 3 zeigt die eingeschaltete Betriebsweise:

In dieser Betriebsweise ist der PLL-Regelkreis geschlossen (D1 und U1 sind nicht auf Tristate gelegt). Die Prozessorbaugruppe kann sich dabei im Master-Mode oder Slave-Mode befinden.

### FIG 4 zeigt die Holdover-Betriebsweise:

In dieser Betriebsweise befindet sich die Prozessorbaugruppe im Master-Mode ist und arbeitet ohne externe Referenz. Der Ausgang der Schleifenfilters beträgt in dieser Betriebsweise 1,5V.

### FIG 5 zeigt die Monitor-VCO-Betriebsweise:

In dieser Betriebsweise entspricht der Ausgangs-Spannungswert des Schleifenfilters dem Spannungswert am VCO-Ziehspannungseingang. Dadurch ist im Moment des Umschaltens auf den eingeschalteten Betrieb (PLL-Regelkreis geschlossen) der richtigen Ausgangspegel am VCO-Ziehspannungseingang sichergestellt (Ein Ausgangspegel am positiven oder negativen Anschlag des Operationsverstärkers hätte einen Frequenzsprung zur Folge der zur Überschreitung der 5ns Maximal-Phasendifferenz-Forderung zwischen beiden Prozessorbaugruppen führen könnte).

## Patentansprüche

1. Synchronisationseinrichtung einer Baugruppe, die den Systemtakt der Baugruppe erzeugt, wobei sie den Systemtakt auf einen von mehreren vorhandenen Referenztakten synchronisiert, mit
a) einem VCO, der den Systemtakt der Baugruppe in Abhängigkeit eines an seinem Steuereingang anliegenden Signals erzeugt,
b) einer Anordnung, die einen Phasendetektor mit nachgeschaltetem Filter umfaßt und pro Referenztakt jeweils ein Mal vorhanden ist, wobei an dem einen Eingang eines Phasendetektors jeweils ein Referenztakt und an dem anderen Eingang jeweils der Systemtakt anliegt,
c) einer Betriebssteuerung, die den Filtern nachgeschaltete Schalter derart steuert, daß jeweils eines der Ausgangssignale der Filter zum Steuereingang des VCO durchschaltet ist,
**dadurch gekennzeichnet, daß**
die genannte Betriebssteuerung weitere Schalter derart steuert, daß bei einer genannten Anordnung, bei der das Ausgangssignal des Filters nicht zum Eingang des VCO durchgeschaltet ist,
- der Ausgang des Phasendetektors auf Tri-State geschaltet ist,
- an den einen Filter-Eingang das Ausgangssignal des Filters zurückgekoppelt ist,
- und an den anderen Filter-Eingang das entkoppelte Signal des Steuereingangs des VCO angekoppelt ist.

2. Synchronisationseinrichtung nach Anspruch 1, **gekennzeichnet durch**
eine Verzögerungseinrichtung, die den Systemtakt vor dem Eingang zum Phasendetektor um die Laufzeitdifferenz zwischen Referenztakt und Systemtakt verzögert.

## Claims

1. Synchronization device of an assembly, which generates the system clock of the assembly, it synchronizing the system clock with one of a plurality of reference clocks present, having
a) a VCO, which generates the system clock of the assembly in a manner dependent on a signal present at its control input,
b) an arrangement which comprises a phase detector with filter connected downstream and is present in each case once per reference clock, in each case a reference clock being present at one input of a phase detector and in each case the system clock being present at the other input,
c) an operating control, which controls switches connected downstream of the filters in such a way that in each case one of the output signals of the filters is switched through to the control input of the VCO,
**characterized in that**
the abovementioned operating control controls further switches in such a way that, in the case of an abovementioned arrangement in which the output signal of the filter is not switched through to the input of the VCO,
- the output of the phase detector is switched to tristate,
- the output signal of the filter is fed back to one filter input,
- and the decoupled signal of the control input of the VCO is coupled to the other filter input.

2. Synchronization device according to Claim 1,
**characterized by**
a delay device, which delays the system clock upstream of the input to the phase detector by the propagation time difference between reference clock and system clock.

## Revendications

1. Dispositif de synchronisation d'un bloc de composants qui génère la cadence de système du bloc en synchronisant la cadence de système sur une des cadences de référence parmi plusieurs cadences existantes, comprenant
a) un oscillateur commandé en tension (VCO) qui génère la cadence de système du bloc de composants en fonction d'un signal appliqué à une entrée de commande,
b) un circuit comprenant un comparateur de phase derrière lequel est monté un filtre et qui est présent à chaque fois pour chaque cadence de référence, une cadence de référence étant appliquée à chaque fois à une des entrées d'un comparateur de phase et la cadence de système étant appliquée à chaque fois à l'autre entrée,
c) une commande de service qui commande les commutateurs montés derrière les filtres de manière à ce qu'un des signaux de sortie des filtres soit transféré à chaque fois à l'entrée de commande de l'oscillateur commandé en tension,
**caractérisé en ce que**
la commande de service mentionnée commande d'autres commutateurs de manière à ce que, avec un circuit mentionné dans lequel le signal de sortie du filtre n'est pas transféré à l'entrée de l'oscillateur commandé en tension,
- la sortie du comparateur de phase soit reliée à un dispositif à trois états,
- le signal de sortie du filtre exerce une rétroaction sur une des entrées du filtre,
- et le signal découplé de l'entrée de commande de l'oscillateur commandé en tension soit couplé à l'autre entrée du filtre.

2. Dispositif de synchronisation selon la revendication 1, **caractérisé par** un dispositif à retard qui retarde la cadence de système avant l'entrée menant au comparateur de phase dans une mesure correspondant à la différence des délais entre la cadence de référence et la cadence de système.
